# EUROPEAN PATENT SPECIFICATION

(11) **EP 1 374 651 B1**
(45) Date of publication and mention of the grant of the patent: **15.11.2006**
(21) Application number: 02718745.9
(22) Date of filing: 28.03.2002
(51) Int. Cl.: H05K 3/28, H01L 21/56, H01L 23/28

(54) **ENCAPSULATION ARRANGEMENT**
VERKAPSELUNGSANORDNUNG
SYSTEME D'ENCAPSULATION

(30) Priority: 28.03.2001 SE 0101107
(43) Date of publication of application: 02.01.2004
(73) Proprietor: TELEFONAKTIEBOLAGET LM ERICSSON (publ), 164 83 Stockholm (SE)
(72) Inventor: TÖRNQVIST, Hakan, S-413 06 Göteborg (SE); JOHANSSON, Sophia, S-413 06 Göteborg (SE)
(74) Representative: Westman, Per Börje Ingemar
(86) International application number: PCT/SE2002/000635
(87) International publication number: WO 2002/080638

(56) References cited:
- EP-A2- 0 504 634
- EP-A2- 0 714 125
- EP-A2- 0 807 971
- US-A- 6 087 200
- PATENT ABSTRACTS OF JAPAN & JP 02 260 547 A (POLYPLASTICS CO) 23 October 1990

## Description

### TECHNICAL FIELD OF THE INVENTION

The present invention relates to a method and an encapsulation arrangement for encapsulating an electric component arranged on a carrying structure.

### BACKGROUND OF THE INVENTION

To achieve a cost effective environmental protection when packaging electrical modules, especially microwave modules, a non-hermetic sealing can be used. Especially, a naked chip must be protected against mechanical stress, moisture and pollutions. Moreover, in case of microwave circuits, the material protecting the chip should not affect the microwave characteristics at high frequencies. It is also desired that the protective material does not cause high thermal expansion, so that the wire bonds, chip, and the substrate are affected mechanically.

It has also been observed that the commercially available protective material is not suitable for high frequency (e.g. over 1 GHz) applications. In particular, thermal mismatch is a problem when a large area, for example in Multichip Modules (MCMs), is encapsulated.

For protecting naked chips against environmental influences, traditionally so-called glob top technique is used. An encapsulant is dispensed to form a glob over the chip and the electrical interconnections, hence the term glob-top encapsulant. Glob-top encapsulation was originally introduced for consumer packages such as video games, but the demand for miniaturized circuitry led to the use of glob-top as the preferred assembly method for many types of products including smart credit cards, microprocessor circuitry, and complex hybrids. This encapsulation technology allows the manufacturer to make relatively thin devices, and many companies produce packages with cost equal to or less than conventional plastic packages.

Typical glob-top compositions include epoxy or silicone encapsulating resins, which provide protection against corrosion, vibration and mechanical stresses. The purpose of an encapsulant is to protect the chip and fragile wire bonds. An encapsulant should not create unusual stresses during thermal cycling, and it should protect the chip from mechanical shock, moisture, and various chemicals. Matching the coefficient of thermal expansion to the substrate and the chip is critical for long-term dimensional stability and proper sealing of leads to prevent penetration of moisture and ionic contaminants. Encapsulants must have low moisture absorption and be of high purity, i.e., a low level of ionic contaminants such as lithium, sodium, potassium, and chlorine ions. This is very important because ionic contaminants can result in corrosion of chip metallizations under conditions of high humidity. Another significant problem with glob-top is its high dielectric constant, which strongly affects the microwave characteristics at high frequencies.

Moreover, thermal mismatch between the glob-top material, the chip and the substrate material causes shear fractures on wire bonds and cracks on the substrate in case of thermal cycling. Generally, this is the case when glob-top is provided on a large area.

There have been attempts to use airfield microspheres made of glass as glob-top material. The air in the spheres reduces the dielectric constant for the glob-top. However, there are no commercially available products. The drawback of using high amount of glass is the increase of the viscosity, which obstructs the dispensing and wetting of chip, especially under the wire bonds. The wetting problem may result in air containments, which can explode during the curing process. Additionally, the glass beads result in an increase of elasticity coefficient of the material, which implies more mechanical stress on the wire bonds under thermal expansion.

US 3,670,091 describes a compressible medium dispersed throughout a somewhat flexible matrix, so as to provide a pre-coat for encapsulated electrical components that reduces the stresses occurring thereon. The stresses relieved could be produced either from the component or from the outer encapsulant. The design of the system is such that the low pressures exerted during the application of the final coating do not substantially collapse or render useless the effective stress reducing characteristics of the intermediate pre-coat.

A method of forming a shield gasket is shown in WO 02/052913, which falls under the provisions of Article 54 (3) EPC.

According to EP 807 971, an ultrahigh-frequency electronic component has an ultrahigh-frequency chip encased in a molded-resin package. The ultrahigh-frequency electronic component includes a first sealing layer encasing the ultrahigh-frequency chip therein and a second sealing layer encasing the first sealing layer therein. The first sealing layer contains a number of voids or minute air bubbles therein which are effective in reducing the permittivity of the first sealing layer. The sealing layer consists of resin containing air bubbles. The resin does not exhibit same characteristics as the material used according to the present invention, thus not fulfilling the advantages of the invention as mentioned below.

### SUMMARY OF THE INVENTION

Thus, the main object of the present invention is to provide a method as defined in claims 6 and 13 and an encapsulant as defined in claim 1 that overcome the above-mentioned problems.

Other advantages of the invention will be appreciated when reading the following description.

For these reasons, the initially mentioned encapsulation arrangement consists of a plurality of expandable plastic particles, wherein each particle encapsulates a gaseous medium. Most preferably, said plastic particles expand when they are exposed to heat. The arrangement is part of a glob-top encapsulation. Preferably, said plastic particles are provided as microspheres or micro-balloons, which are easy to dispense. According to a preferred embodiment, said plastic particle material is a polymer.

For dispensing reasons the plastic particles encapsulating gas are provided in a die material. The plastic particles encapsulating gas are dispensed onto an encapsulation area by means of a dispenser. The plastic particles and die material are cured.

Preferably, the particles are expanded in a temperature range of 100 °C to 210 °C, preferably from 110 °C to 190 °C, and the curing temperature is from 100 °C to 210 °C, preferably from 110 °C to 190 °C

The die material may consist of epoxies, silicones or phenols.

Preferably, the encapsulation arrangement is for an electric component which is a naked chip, and which can be a microwave circuit for high frequencies.

The invention also refers to a method for encapsulating an electric component arranged on a carrying structure. The method comprises the steps of dispensing a plurality of plastic particles provided in a die material, each particle encapsulating gaseous medium, and heating said plastic particles to expand and cure.

### BRIEF DESCRIPTION OF THE DRAWINGS

In the following, the invention will be described in a non-limiting way with reference to the accompanying drawings, in which:
- Figs. 1-4: illustrate, in a schematic way, the steps of applying of an encapsulation arrangement according to the invention
- Fig. 5: illustrates a second example of the encapsulation according to the invention, and
- Figs. 6a, 6b: illustrate schematically the expansion of microspheres in an encapsulant, according to the invention.

### DETAILED DESCRIPTION OF THE EMBODIMENTS

According to the invention, the encapsulation arrangement consists of gas filled plastic (micro) beads or spheres instead of glass. Surprisingly, it has been observed that plastic microspheres used in the encapsulant have low dielectric constant, higher coefficient of fullness, low viscosity and lower elasticity coefficient.

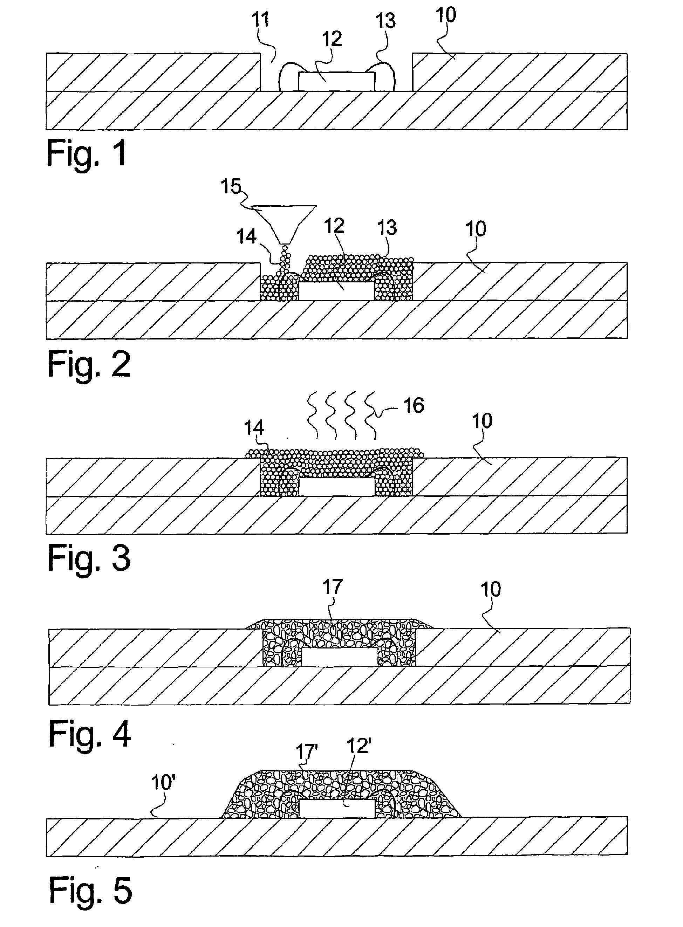

For better understanding of the features of the present invention, it is described in conjunction with illustrative examples shown in Figs. 1-5. Figs. 1 to 4 illustrate one example of the steps of applying and curing the encapsulation arrangement on a carrier structure.

Fig. 1 is a cross section through the carrier structure 10, such as a printed circuit board, a substrate or the like. A cavity 11 is arranged on one surface of the carrier 10 for receiving an electrical component 12, such as a circuit and particularly a naked circuit for microwave applications. The electric component is connected to circuit conductors (not shown) by means of wire bonds 13. The component is placed in the cavity and fixed, e.g. by means of an adhesive agent.

In Fig. 2, the glob-top material consisting of plastic, gas filled microspheres 14 are dispensed by means of a dispenser 15.

### Examples of microspheres that can be used are:

EXPANCEL^{®} (by Akzo Nobel), which comprises spherical plastic particles. The microspheres consist of a polymer shell encapsulating a gas. When the gas inside the shell is heated, it increases its pressure and the thermoplastic shell softens, resulting in a dramatic increase in the volume of the microspheres. Dualite^{®} and MICROPEARL^{™} (by Pierce & Stevens), which are heat expandable polymeric microspheres and expand to form a low-density sphere.

Of course, above products are given as examples and other plastic microspheres may also be used. Moreover, the invention is not limited to the spherical particles and particles having other shapes can also be used.

Microspheres can have different sizes for different applications; a typical diameter for non-expanded spheres is 1-50 µm, which are expanded to a diameter of 30-300 µm. Epoxies, silicones, phenols and similar material can be used as die material.

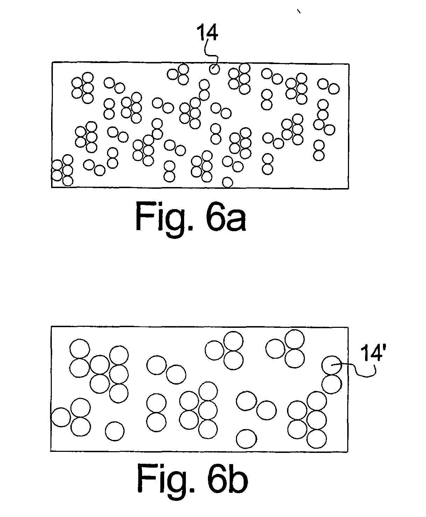

In Fig. 3, the dispensed microspheres are exposed to heat 16 or other radiation that generates heat resulting in expansion of spheres. The expansion and curing temperature may range from 100 °C to 210 °C, preferably from 110 °C to 190 °C. Most of microspheres have curing temperatures within the expansion temperature range. Figs. 6a and 6b show, in a schematic way, the non-expanded and expanded micro spheres 14 and 14', respectively, in the same section of the encapsulation.

Fig. 4 shows the final stage, where the encapsulation arrangement 17 has cured and seals the component.

In Fig. 5, another example is shown, in which a circuit 12' is arranged directly on a substrate 10', and provided with the encapsulation arrangement 17' according to the invention.

The advantages of the encapsulation material according to the invention compared to glass spheres can be summarized by:
■ The expanded (and cured) material has a low dielectric coefficient, which results in low losses at high frequencies.
■ The small size of non-expanded particles allows a higher filling ratio, which also allows lower dielectric coefficient.
■ The small size of a particle also results in lower viscosity and reliable dispensing.
■ The plastic spheres have the advantage of not being crushed in the dispenser, e.g. a feed gear, because they are softer, smaller and more flexible.
■ The expanded spheres have lower elasticity module, which results in lower mechanical stress.
■ The stresses from the thermal mismatch are absorbed easier by the material with lower elasticity module; thus, fractures in the substrate and wire bonds can be avoided.

The invention is not limited to the shown embodiments but can be varied in a number of ways without departing from the scope of the appended claims and the arrangement and the method can be implemented in various ways depending on application, functional units, needs and requirements etc.

## Claims

1. An encapsulation arrangement (17, 17') encapsulating an electric component (12, 12') arranged on a carrying structure (10, 10'),
***characterised in***
**that** said encapsulation arrangement (17, 17') consists of a plurality of expandable plastic particles (14) provided in a die material, wherein each particle encapsulates a gaseous medium.

2. The encapsulation arrangement of claim 1,
***characterised in***
**that** said plastic particles (14) expand when they are exposed to heat.

3. The encapsulation arrangement of claim 1 or 2,
***characterised in***
**that** said arrangement is part of a glob-top encapsulation.

4. The encapsulation arrangement according to any of preceding claims,
***characterised in***
**that** said plastic particles are provided as microspheres or micro-balloons.

5. The encapsulation arrangement according to any of preceding claims,
***characterised in***
**that** said plastic particle material is a polymer.

6. The method of forming an encapsulation arrangement according to any of preceding claims,
***characterised in***
**that** said plastic particles (14) encapsulating gas are dispensed onto an encapsulation area by means of a dispenser (15).

7. The method of forming an encapsulation arrangement according claim 6,
***characterised in***
**that** said plastic particles and die material are cured.

8. The encapsulation arrangement according to any of preceding claims,
***characterised in***
**that** the expansion temperature for said particles ranges from100 °C to 210 °C, preferably from 110 °C to 190 °C.

9. The encapsulation arrangement according claim 8,
***characterised in***
**that** the curing temperature ranges from 100 °C to 210 °C, preferably from 110 °C to 190 °C.

10. The encapsulation arrangement according claim 8,
***characterised in***
**that** said die material consists of epoxies, silicones or phenols.

11. The encapsulation arrangement according to any of preceding claims,
***characterised in***
**that** said electric component is a naked chip.

12. The encapsulation arrangement according claim 11,
***characterised in***
**that** said naked chip is a microwave circuit for high frequencies.

13. A method for encapsulating an electric component (12, 12') arranged on a carrying structure (10, 10'),
***characterised by***
dispensing a plurality of plastic particles (14) to a space provided in a die material receiving said electric component, each particle encapsulating a gaseous medium, and heating said plurality of plastic particles (14) to expand and cure, and encapsulate said electric component.

## Patentansprüche

1. Einkapselungsanordnung (17, 17'), die eine elektrische Komponente (12, 12') einkapselt, die auf einer Tragestruktur (10, 10') angeordnet ist,
**dadurch gekennzeichnet, dass**
die Einkapselungsanordnung (17, 17') aus einer Vielzahl von dehnbaren Plastikpartikeln (14) zusammengesetzt ist, die in einem Modellformmaterial bereitgestellt sind, wobei jedes Partikel ein Gasmedium einkapselt.

2. Einkapselungsanordnung gemäß Anspruch 1, **dadurch gekennzeichnet, dass** die Plastikpartikel (14) sich ausdehnen, wenn sie Hitze ausgesetzt werden.

3. Einkapselungsanordnung gemäß Anspruch 1 oder 2, **dadurch gekennzeichnet, dass** die Anordnung ein Teil einer Glob-Top-Einkapselung ist.

4. Einkapselungsanordnung gemäß einem der vorigen Ansprüche, **dadurch gekennzeichnet, dass** die Plastikpartikel als Mikrosphären oder Mikroballons bereitgestellt sind.

5. Einkapselungsanordnung gemäß einem der vorigen Ansprüche, **dadurch gekennzeichnet, dass** das Plastikpartikelmaterial ein Polymer ist.

6. Verfahren zum Bilden einer Einkapselungsanordnung gemäß einem der vorigen Ansprüche, **dadurch gekennzeichnet, dass** die ein Gas einkapselnden Plastikpartikel (14) auf eine Einkapselungsfläche mittels eines Ausgabegerätes (15) ausgebracht werden.

7. Verfahren zum Bilden einer Einkapselungsanordnung gemäß Anspruch 6, **dadurch gekennzeichnet, dass** die Plastikpartikel und das Modellformmaterial gehärtet werden.

8. Einkapselungsanordnung gemäß einem der vorigen Ansprüche, **dadurch gekennzeichnet, dass** die Ausdehnungstemperatur für die Partikel von 100°C bis 210°C, vorzugsweise von 110°C bis 190°C, reicht.

9. Einkapselungsanordnung gemäß Anspruch 8, **dadurch gekennzeichnet, dass** die Aushärtetemperatur von 100°C bis 210°C, vorzugsweise von 110°C bis 190°C, reicht.

10. Einkapselungsanordnung gemäß Anspruch 8, **dadurch gekennzeichnet, dass** das Modellformmaterial aus Epoxid, Silikonen oder Phenolen besteht.

11. Einkapselungsanordnung gemäß einem der vorigen Ansprüche, **dadurch gekennzeichnet, dass** die elektrische Komponente ein nackter Chip ist.

12. Einkapselungsanordnung gemäß Anspruch 11, **dadurch gekennzeichnet, dass** der nackte Chip ein Mikrowellenschaltkreis für Hochfrequenzen ist.

13. Verfahren zum Einkapseln einer elektrischen Komponente (12, 12'), die auf einer Tragestruktur (10, 10') angeordnet ist, **gekennzeichnet durch** Ausbringen einer Vielzahl von Plastikpartikeln (14), die in einem Modellformmaterial bereitgestellt sind, auf einem Raum, der die elektrische Komponente empfängt, wobei jedes Partikel ein Gasmedium einkapselt, und Erhitzen der Vielzahl von Plastikpartikeln (14), um sich auszudehnen und zu härten, und die elektrische Komponente einzukapseln.

## Revendications

1. Agencement d'encapsulation (17, 17') encapsulant un composant électrique (12, 12') agencé sur une structure porteuse (10, 10'),
**caractérisé en ce que**
ledit agencement d'encapsulation (17, 17') consiste en une pluralité de particules en matière plastique dilatables (14) réalisées dans un matériau de matrice où chaque particule encapsule un milieu gazeux.

2. Agencement d'encapsulation selon la revendication 1,
**caractérisé en ce que**
lesdites particules de matière plastique (14) se dilatent lorsqu'elles sont exposées à la chaleur.

3. Agencement d'encapsulation selon la revendication 1 ou 2,
**caractérisé en ce que**
ledit agencement fait partie d'une encapsulation de type "glob-top".

4. Agencement d'encapsulation selon l'une quelconque des revendications précédentes,
**caractérisé en ce que**
lesdites particules de matière plastique sont fournies sous la forme de microsphères ou de microballons.

5. Agencement d'encapsulation selon l'une quelconque des revendications précédentes,
**caractérisé en ce que**
ledit matériau de particules de matière plastique est un polymère.

6. Procédé de formation d'un agencement d'encapsulation selon l'une quelconque des revendications précédentes,
**caractérisé en ce que**
lesdites particules de matière plastique (14) encapsulant le gaz sont distribuées sur une zone d'encapsulation au moyen d'un distributeur (15).

7. Procédé de formation d'un agencement d'encapsulation selon la revendication 6,
**caractérisé en ce que**
lesdites particules de matière plastique et le matériau de matrice sont durcis.

8. Agencement d'encapsulation selon l'une quelconque des revendications précédentes,
**caractérisé en ce que**
la température de dilatation pour lesdites particules va de 100°C à 210°C, de préférence de 110°C à 190°C.

9. Agencement d'encapsulation selon la revendication 8,
**caractérisé en ce que**
la température de durcissement va de 100°C à 210°C, de préférence de 110°C à 190°C.

10. Agencement d'encapsulation selon la revendication 8,
**caractérisé en ce que**
ledit matériau de matrice est constitué de résines époxy, de silicones ou de phénols.

11. Agencement d'encapsulation selon l'une quelconque des revendications précédentes,
**caractérisé en ce que**
ledit composant électrique est une puce nue.

12. Agencement d'encapsulation selon la revendication 11,
**caractérisé en ce que**
ladite puce nue est un circuit micro-onde pour les hautes fréquences.

13. Procédé d'encapsulation d'un composant électrique (12, 12') agencé sur une structure porteuse (10, 10'),
**caractérisé par**
le fait de distribuer une pluralité de particules de matière plastique (14) prévues dans un matériau de matrice à un espace recevant ledit composant électrique, chaque particule encapsulant un milieu gazeux, et le fait de chauffer ladite pluralité de particules de matière plastique (14) pour qu'elles se dilatent et durcissent, et encapsulent ledit composant électrique.
